# FASCICULE DE BREVET EUROPEEN

(11) **EP 2 843 715 B1**
(45) Date de publication et mention de la délivrance du brevet: **28.11.2018**
(21) Numéro de dépôt: 14182155.3
(22) Date de dépôt: 25.08.2014
(51) Int. Cl.: H01L 33/06, H01L 33/00

(54) **Structure semiconductrice à zones d'émission commutables, procédé de fabrication d'une telle structure et dispositif semiconducteur comportant une telle structure**
Halbleiterstruktur mit schaltbaren Emissionsbereichen, Herstellungsverfahren einer solchen Struktur und Halbleitervorrichtung, die eine solche Struktur umfasst
Semiconductor structure with switchable emission regions, method for manufacturing such a structure and semiconductor device comprising such a structure

(30) Priorité: 28.08.2013 FR 1358242
(43) Date de publication de la demande: 04.03.2015
(73) Titulaire: Commissariat à l'Énergie Atomique et aux Énergies Alternatives, 75015 Paris (FR)
(72) Inventeur: Robin, Ivan-Christophe, 38000 Grenoble (FR); Tchelnokov, Alexei, 38240 Meylan (FR)
(74) Mandataire: Brevalex

(56) Documents cités:
- EP-A1- 2 149 919
- US-A- 5 851 905
- US-A1- 2011 001 121

## Description

### DOMAINE TECHNIQUE

L'invention se rapporte au domaine des dispositifs d'émission de lumière.

Que ce soit pour l'éclairage ou l'affichage d'informations, en raison d'une quête constante d'amélioration des rendements énergétiques des appareillages du quotidien, les structures semiconductrices adaptées pour émettre de la lumière sont devenues ces dix dernières années incontournables.

Ainsi, ces structures sont actuellement à la base de recherches intenses pour améliorer leurs performances, ceci notamment en ce qui concerne leurs rendements d'émission et les possibilités de variation des conditions d'éclairage offertes.

L'invention se rapporte donc plus particulièrement à une structure semiconductrice à zones d'émissions commutables, à un procédé de fabrication d'une telle structure et à un dispositif comportant une telle structure.

### ÉTAT DE LA TECHNIQUE ANTÉRIEURE

Les structures semiconductrices destinées à émettre de la lumière comportent généralement deux régions semiconductrices en contact l'une avec l'autre, la première région semiconductrice étant d'un premier type de conductivité et la deuxième région semiconductrice comprenant au moins une portion d'un deuxième type de conductivité. Ainsi, les structures semiconductrices présentent une jonction semiconductrice entre leurs première et deuxième régions semiconductrices.

La deuxième région de ce type de structure semiconductrice présente généralement une première portion comportant une concentration en porteurs majoritaires réduite vis-à-vis de la première région de manière à ce que la jonction s'étende principalement dans ladite deuxième région et que les recombinaisons de paires électron-trou génératrices de photons aient principalement lieu dans cette première portion. Ceci est usuellement obtenu par l'utilisation d'une première portion du type non intentionnellement dopé.

On entend ci-dessus et dans le reste de ce document, par jonction semiconductrice, la zone de charge d'espace qui se crée à la jonction entre deux régions semiconductrices présentant des types de conductivité opposés tels que, par exemple, entre deux régions semiconductrice dont l'une est du type de conductivité pour lequel les porteurs majoritaires sont des électrons et l'autre est du type de conductivité pour lequel les porteurs majoritaires sont des trous.

On entend ci-dessus et dans le reste de ce document par « du type non intentionnellement dopé », que la région semiconductrice, ou la portion de région semiconductrice, est réalisée dans un matériau dans lequel il n'a pas été intentionnellement incorporé d'éléments dopants lors de sa formation. Ainsi une telle région, ou portion de région, présente une concentration en porteurs majoritaires qui reste contenue, par exemple, dans le cas du nitrure de gallium GaN, de l'ordre de 10¹⁶cm⁻¹ avec une conductivité du type dans lequel les porteurs majoritaires sont des électrons.

Afin d'optimiser le taux de recombinaisons de paires électron-trou dans cette même première portion, cette dernière comprend généralement au moins une zone de confinement adaptée pour confiner au moins un type de porteurs, tels que des puits quantiques.

Ainsi de telles structures permettent de fournir une émission de lumière possédant un bon rendement énergétique vis-à-vis des sources de lumière incandescente ou les tubes fluo-compacts. Néanmoins, si une telle zone de confinement permet d'optimiser le nombre recombinaisons de paires électron-trou, ces dernières ont principalement lieu dans cette zone de confinement et le volume dans lequel a lieu les recombinaisons est donc relativement faible. Il en résulte une capacité d'émission maximale qui est limitée.

Afin de palier ce problème, il est connu d'aménager une pluralité de zones de confinement, typiquement 3 à 6, pour augmenter d'autant le volume dans lequel a lieu les recombinaisons de paires électron-trou.

Néanmoins, si la multiplication des zones de confinement permet théoriquement d'augmenter le volume dans lequel les recombinaisons de paires électron-trou ont lieu, les calculs et les expériences sur de telles structures, tels que décrits dans les travaux de A. DAVID et al. publiés en 2008 dans la revue scientifique « Applied Physics Letters » n°92 pages 053502 et les travaux de S. H. HAN et al. publiés en 2009 dans la revue scientifique « Applied Physics letters » n°94 pages 231123, ont montré que les recombinaisons de paires électron-trou n'ont en fait lieu que dans une seule des zones de confinement.

Les documents US 2011/001121 A1 et US 5 851 905 A divulguent des structures de diode électroluminescente comportant au moins deux zones de confinement.

### EXPOSÉ DE L'INVENTION

La présente invention vise à remédier à cet inconvénient.

Un des buts de l'invention est donc de fournir une structure semiconductrice destinée à émettre de la lumière et qui, comportant au moins deux zones de confinement de porteurs, autorise une émission de lumière avec des recombinaisons de paires électron-trou qui ont principalement lieu dans au moins deux zones de confinement.

Un autre but de l'invention est de fournir une structure semiconductrice destinée à émettre de la lumière et qui, comportant au moins deux zones de confinement, permet de commuter la ou les zones de confinement dans laquelle ou lesquelles ont lieu les recombinaisons de paires électron-trou, ceci afin de moduler le taux d'émission respectif de chacune des zones et de modifier le spectre d'émission de la structure.

L'invention a plus particulièrement pour but d'autoriser la fourniture d'une structure semiconductrice dont la longueur d'onde d'émission peut être adaptée en fonction des besoins.

A cet effet l'invention concerne une structure semiconductrice, destinée à émettre de la lumière, comportant :
- une première région semiconductrice d'un premier type de conductivité,
- une deuxième région semiconductrice présentant, au moins sur une portion, un deuxième type de conductivité de manière à former une jonction semiconductrice avec la première région, cette deuxième région présentant au moins une première portion en contact avec la première région et dans laquelle première portion s'étend au moins partiellement la jonction semiconductrice, cette première portion comprenant au moins une première et une deuxième zone de confinement de porteurs pour au moins un type de porteurs,
- la structure comportant au moins un premier moyen de polarisation de la première portion adapté pour soumettre directement la première portion à une polarisation extérieure afin de modifier la répartition des porteurs d'au moins un type de conductivité par rapport à la première et à la deuxième zone de confinement.

Cette modification de la répartition des porteurs d'au moins un type de conductivité par rapport à la première et à la deuxième zone de confinement permet de sélectionner la ou les zones de confinement dans laquelle l'émission de lumière a lieu.

La première et la deuxième zone de confinement présentent des largeurs de bandes interdites différentes l'une de l'autre.

Le premier moyen de polarisation peut être une grille ou un contact Schottky ceci de manière à soumettre directement la première portion à une polarisation extérieure sans injection de porteurs à partir de ce moyen de polarisation, un tel moyen de polarisation est à opposer à un contact électrique du type ohmique qui entraîne l'injection de porteurs lors de l'application d'une polarisation et qui ne fournit donc pas une simple soumission à une polarisation.

On entend ci-dessus et dans le reste de ce document par « modification de la répartition des porteurs d'au moins un type de conductivité » que le moyen de polarisation est adapté pour modifier la répartition des porteurs d'au moins un type de conductivité ceci en créant par effet de champ, pour ce type de porteurs, soit une zone d'accumulation, de déplétion, voire même d'inversion. Une telle modification de la répartition de porteurs permet de modifier la répartition des lignes de courant dans la zone semiconductrice concernée et la répartition de la zone de charge d'espace qui s'étend dans cette dernière. Dans le cas où la zone semiconductrice est du type non intentionnellement dopé et présente donc une conductivité faiblement polarisée, la concentration en porteurs majoritaires est influencée par les zones adjacentes et il est donc possible d'obtenir pour ce type de zone semiconductrice aussi bien une accumulation de trous que d'électrons.

Bien entendu une modification de la répartition des porteurs d'un type de conductivité n'exclut pas que ledit moyen de polarisation influence la répartition des porteurs de l'autre type de conductivité.

Avec une telle structure, la mise en oeuvre du premier moyen de polarisation permet de modifier la répartition des porteurs d'au moins un type de conductivité dans la première portion par rapport à la première et à la deuxième zone de confinement, ceci par un effet de champ. Ainsi, il est donc possible, de modifier cette répartition de manière à sélectionner la zone de confinement dans laquelle des deux zones de confinement l'émission de lumière a principalement lieu. Il est également possible, avec une polarisation de cette dernière, de modifier la répartition des porteurs d'au moins un type de conductivité de manière que l'émission ait lieu à la fois dans la première et la deuxième zone de confinement. On augmente ainsi le volume dans lequel ont lieu les recombinaisons de paires électron-trou vis-à-vis des structures de l'art antérieur ne présentant pas un tel premier moyen de polarisation. Cette dernière possibilité permet d'augmenter la capacité d'émission d'une telle structure vis-à-vis des structures de l'art antérieur.

De plus, avec une telle structure, dans le cas où les zones de confinement sont adaptées pour présenter des largeurs de bande interdite, et donc des longueurs d'onde d'émission, différentes l'une de l'autre, il est possible, en modifiant la répartition des porteurs d'au moins un type de conductivité vis-à-vis des zones de confinement au travers du premier moyen de polarisation, de changer la longueur d'onde d'émission de la structure.

La première portion peut comporter une concentration en porteurs majoritaires qui est réduite vis-à-vis de la première région, la concentration en porteurs majoritaires de la première portion de la deuxième région étant préférentiellement inférieure d'au moins dix fois celle de la première région, voire inférieure à cinquante fois celle de la première région.

La première portion peut être du type non intentionnellement dopée.

Une telle concentration réduite en porteurs majoritaires de la première portion de la deuxième région vis-à-vis de la première région est particulièrement favorable pour permettre une modification significative de la répartition de porteurs aussi bien du premier type de conductivité que du deuxième type de conductivité. Ainsi, la tension à appliquer au premier moyen de polarisation pour fournir une modification de la répartition de la jonction donnée reste réduite par rapport à une structure présentant une première portion de la deuxième région comportant une concentration en porteurs majoritaires plus importante.

Chaque zone de confinement peut comporter un puits quantique pour au moins un type de porteurs.

La portion du deuxième type de conductivité, dite deuxième portion, peut être distincte de la première portion.

Ainsi l'invention concerne également une structure semiconductrice, destinée à émettre de la lumière, comportant :
- une première région semiconductrice d'un premier type de conductivité,
- une deuxième région semiconductrice présentant, au moins une première et une deuxième portion, la première portion étant en contact avec la première région et comportant une concentration en porteurs majoritaires réduite vis-à-vis de la première région, la deuxième portion étant d'un deuxième type de conductivité opposé au premier type de conductivité de manière à former une jonction semiconductrice avec la première région qui s'étend dans la première portion, cette même première portion comprenant au moins une première et une deuxième zone de confinement de porteurs pour au moins un type de porteurs,
la structure comportant au moins un premier moyen de polarisation de la première portion adapté pour soumettre directement la première portion à une polarisation extérieure afin de modifier la répartition des porteurs d'au moins un type de conductivité dans la première portion par rapport à la première et à la deuxième zone de confinement.

Une telle structure bénéficie particulièrement de l'invention de par sa première portion. En effet, la jonction semiconductrice s'étend, dans une telle structure, principalement dans cette première portion et peut donc aisément être modulée de manière à sélectionner la ou les zones de confinements dans laquelle ou lesquelles l'émission a lieu.

La première portion peut être du type non intentionnellement dopé.

Une telle première portion de la deuxième région est particulièrement favorable pour une modification significative de la répartition aussi bien des porteurs du premier type de conductivité que des porteurs du deuxième type de conductivité. En effet, il suffit d'une faible quantité d'un type de porteurs pour en modifier la répartition et ainsi modifier la répartition de l'émission entre la première et la deuxième zone de confinement.

On entend ci-dessus et dans le reste de ce document par un type de porteurs, les porteurs correspondant à un type de conductivité, c'est-à-dire, les porteurs majoritaires du type de conductivité. Ainsi, lorsqu'il est indiqué dans ce document, respectivement le premier et le deuxième type de porteurs, il faut entendre respectivement les porteurs majoritaires correspondant au premier type et au deuxième type de conductivité. De même, par porteurs du premier et du deuxième type de conductivité, il faut entendre respectivement les porteurs majoritaires correspondant au premier type et au deuxième type de conductivité.

La première portion peut être la portion du deuxième type de conductivité de la deuxième région.

Ainsi l'invention concerne également une structure semiconductrice, destinée à émettre de la lumière, comportant :
- une première région semiconductrice d'un premier type de conductivité,
- une deuxième région semiconductrice présentant, au moins sur une première portion, un deuxième type de conductivité de manière à former une jonction semiconductrice avec la première région, cette première portion étant en contact avec la première région et dans laquelle première portion s'étend la jonction semiconductrice, cette même première portion comprenant au moins une première et une deuxième zone de confinement de porteurs pour au moins un type de porteurs,
la structure comportant au moins un premier moyen de polarisation de la première portion adapté pour soumettre directement la première portion à une polarisation extérieure afin de modifier la répartition des porteurs d'au moins un type de conductivité dans la première portion par rapport à la première et à la deuxième zone de confinement.

Une telle structure peut être obtenue avec un nombre réduit d'étapes de fabrication par rapport à une structure présentant une deuxième région comportant deux portions distincts. En effet, il est possible de former la deuxième région en une seule étape sans nécessiter d'étape supplémentaire de dopage ou de croissance supplémentaire à celles nécessaires pour former la première portion de la deuxième région.

Le premier moyen de polarisation peut être agencé à proximité de l'une parmi la deuxième portion et la première région relativement à l'autre parmi la deuxième portion et la première région de manière qu'une polarisation de ce dernier entraîne dans la première portion une modification de la répartition des porteurs parmi respectivement les porteurs du deuxième type de conductivité et du premier type de conductivité.

Un tel premier moyen de polarisation permet de modifier la répartition des porteurs d'un type de conductivité parmi le premier et le deuxième type de conductivité par rapport à la première et à la deuxième zone de confinement qui est particulièrement efficace pour ce type de conductivité, le premier moyen étant agencé à proximité d'une zone semiconductrice fournissant un réservoir de porteurs de ce type de conductivité.

Le premier moyen de polarisation peut être agencé à proximité de la deuxième portion relativement à la première région de manière qu'une polarisation de ce dernier entraîne dans la première portion une modification de la répartition des porteurs du deuxième type de conductivité.

Le premier moyen de polarisation peut être agencé à proximité de la première région relativement à la deuxième portion de manière qu'une polarisation de ce dernier entraîne dans la première portion une modification de la répartition des porteurs du premier type de conductivité.

Le premier moyen de polarisation peut être agencé sensiblement à équidistance par rapport à la deuxième portion et de la première région pour qu'une polarisation de ce dernier entraîne une modification de la répartition des porteurs du premier et du deuxième type de conductivité dans la première portion.

Dans une telle configuration, le premier moyen, en étant à équidistance des zones semiconductrices présentant le premier et le deuxième type de conductivité, est à même d'influencer la répartition des porteurs aussi bien du premier que du deuxième type de conductivité.

Il peut en outre être prévu un deuxième moyen de polarisation adapté pour soumettre directement la première portion à une deuxième polarisation extérieure afin de modifier la répartition des porteurs d'au moins un type de conductivité dans la première portion par rapport à la première et à la deuxième zone de confinement.

Ledit deuxième moyen de polarisation peut être agencé à proximité de l'autre parmi la deuxième portion et la première région par rapport au premier moyen de polarisation pour qu'une polarisation de ce deuxième moyen de polarisation entraîne une modification dans la première portion de la répartition des porteurs parmi respectivement les porteurs du premier et du deuxième type de conductivité.

De tels deuxièmes moyens permettent de modifier, en parallèle et de manière distincte à la modification générée par le premier moyen de polarisation la répartition des porteurs d'au moins un type de conductivité de manière à obtenir un contrôle fin de la répartition des porteurs dans la première portion vis-à-vis de la première et de la deuxième zone de confinement. Une telle possibilité est particulièrement adaptée pour une structure comportant dans la première portion de la deuxième région plus de deux zones de confinement.

Le premier moyen de polarisation étant agencé à proximité de la deuxième portion, ledit deuxième moyen de polarisation peut être agencé à proximité de la première région par rapport au premier moyen de polarisation pour qu'une polarisation de ce deuxième moyen de polarisation entraîne une modification dans la première portion de la répartition des porteurs du premier type de conductivité.

Le premier moyen de polarisation étant agencé à proximité de la première région, ledit deuxième moyen de polarisation peut être agencé à proximité de la deuxième portion par rapport au premier moyen de polarisation pour qu'une polarisation de ce deuxième moyen de polarisation entraîne une modification dans la première portion de la répartition des porteurs du deuxième type de conductivité.

De plus, pour un premier et un deuxième moyen agencés respectivement à proximité de l'un et de l'autre parmi la deuxième portion et la première région, ces deux moyens de polarisation permettent de modifier indépendamment la répartition dans la première portion des porteurs du premier et du deuxième type de conductivité par rapport à la première et à la deuxième zone de confinement. Ainsi, il est possible en jouant sur la première et la deuxième polarisation extérieure de sélectionner la ou les zones dans laquelle ou lesquelles a lieu l'émission.

La première portion peut être une couche s'étendant selon un plan de couche et comportant une première et une deuxième face, la première et la deuxième zone de confinement s'étendant selon le plan de couche sensiblement parallèlement l'une à l'autre, la deuxième portion de la deuxième région et le premier moyen de polarisation étant agencés de manière complémentaire sur la deuxième face de la première portion.

La première portion de la deuxième région peut présenter la forme d'une couche comportant un plan de couche et une première et une deuxième face, la première et la deuxième zone de confinement s'étendant selon le plan de couche sensiblement parallèlement l'une à l'autre, et dans laquelle la deuxième portion de la deuxième région est en contact avec la première portion de cette même région sur une partie de la deuxième face de ladite première portion, le premier moyen de polarisation étant agencé pour soumettre à une première polarisation extérieure la première portion le long d'une deuxième partie de la deuxième face qui est complémentaire à la première partie de la deuxième face.

Ces deux configurations de la structure sont particulièrement adaptées pour une structure du type vertical, c'est-à-dire étant formée selon l'épaisseur d'un support semiconducteur.

La première portion de la deuxième région peut s'étendre longitudinalement selon un plan de couche à partir de la première région, la première portion présentant une première et une deuxième face longitudinale, la première et la deuxième zone de confinement s'étendant selon le plan de couche en regard respectivement de la première et de la deuxième face de la première portion, le premier moyen de polarisation étant agencé sur la deuxième face de la première portion.

La première portion de la deuxième région peut s'étendre longitudinalement selon un plan de couche à partir de la première région, la première portion présentant une première et une deuxième face longitudinale, la première et la deuxième zone de confinement s'étendant dans la première portion de la deuxième région selon le plan de couche en regard respectivement de la première et de la deuxième face de la première portion de la deuxième région, le premier moyen de polarisation étant agencé sur la deuxième face de la première portion de la deuxième région de manière à ce qu'une polarisation du premier moyen de polarisation entraîne une modification de la répartition des porteurs d'au moins un type de conductivité.

La deuxième portion de la deuxième région peut être en contact avec la première portion sensiblement à l'opposé de la première région, la première et la deuxième région étant agencées sous la forme d'une couche.

La première portion peut s'étendre longitudinalement entre la première région et la deuxième portion selon un plan de couche, ladite première portion présentant une première et une deuxième face longitudinale, la première et la deuxième zone de confinement s'étendant dans la portion de deuxième région selon le plan de couche en regard respectivement de la première et de la deuxième face de la première portion de la deuxième région, le premier moyen de polarisation étant agencé sur la deuxième face de la première portion de deuxième région à proximité de la deuxième région de manière à ce qu'une polarisation du premier moyen de polarisation entraîne une modification de la répartition des porteurs d'au moins un type conductivité.

La première et la deuxième région peuvent être présentes dans une même couche, cette dernière définissant un plan de couche, la première portion s'étendant longitudinalement à partir de la première région selon le plan de couche, ladite première portion présentant une première et une deuxième face longitudinale, la première et la deuxième zone de confinement s'étendant selon le plan de couche en regard respectivement de la première et la deuxième face de la première portion, le premier moyen de polarisation étant agencé sur la deuxième face de la première portion de deuxième région de manière à ce qu'une polarisation du premier moyen de polarisation entraîne une modification de la répartition des porteurs d'au moins un type conductivité.

De telles configurations sont particulièrement adaptées pour une structure du type planaire.

Le deuxième moyen de polarisation peut être agencé sur l'une de la première et de la deuxième face de la première portion de la deuxième région de manière à ce qu'une polarisation du deuxième moyen de polarisation entraîne une modification de la répartition des porteurs de l'autre type de conductivité parmi le premier et le deuxième dans la première portion.

Avec une telle configuration il est possible de précisément contrôler dans laquelle ou lesquelles des zones de confinement a lieu l'émission.

Le premier moyen de polarisation peut comporter une couche conductrice séparée de la première portion par une couche de matériau isolant, ladite couche conductrice étant positionnée à proximité de la portion de la deuxième région du deuxième type de conductivité.

Une telle configuration du premier moyen de polarisation est particulièrement adaptée pour obtenir une modification de la répartition d'au moins un type de porteurs par effet de champ.

Le deuxième moyen de polarisation peut comporter une couche conductrice séparée de la première portion par une couche de matériau isolant, ladite couche conductrice étant positionnée à proximité de la première région.

La première et la deuxième zone de confinement peuvent chacune présenter une largeur de bande interdite différente de celle de l'autre zone de confinement parmi la première et la deuxième zone de confinement.

Ainsi, en modulant la répartition de la jonction dans la première et la deuxième zone de confinement, et donc la puissance émise dans chacune de ces mêmes zones, il est possible de moduler la longueur d'onde d'émission de la structure.

La deuxième région peut comporter en outre une troisième zone de confinement, la première, la deuxième et la troisième zone de confinement présentant des largeurs de bande interdite adaptées pour que les longueurs d'onde d'émission de ces zones de confinement soient réparties sur une partie de la gamme de longueurs d'ondes du visible et préférentiellement sur une majeure partie de la gamme de longueurs d'onde du visible, voire la totalité de la gamme de longueurs d'onde du visible.

Une telle structure permet une modulation de la longueur d'onde d'émission dans le visible avec notamment la possibilité, lorsque la gamme de longueurs d'onde du visible sur laquelle sont réparties les longueurs d'onde d'émission des zones de confinement est adéquate, d'émettre une lumière sensiblement blanche en modifiant la température d'émission. Ainsi, avec une même structure il est possible de passer d'une émission d'une lumière blanche particulièrement chaude, c'est-à-dire tirant vers les rouges, à une lumière blanche particulièrement froide, c'est-à -dire tirant vers les bleues.

La première, la deuxième et la troisième zone de confinement peuvent être adaptées pour respectivement présenter une longueur d'onde d'émission dans le rouge, le bleu et le vert.

L'invention concerne également un procédé de fabrication d'une structure semiconductrice comportant les étapes de :
- fourniture d'une deuxième région semiconductrice comportant au moins une première portion dans laquelle il est prévu une première et une deuxième zone de confinement de porteurs pour au moins un type de porteurs, ladite deuxième région présentant, au moins sur une portion, un deuxième type de conductivité,
- formation d'une première région semiconductrice d'un premier type de conductivité en contact avec la deuxième région de manière à former une jonction semiconductrice avec la portion de la deuxième région qui est du deuxième type de conductivité, ladite jonction s'étendant dans la première portion de la deuxième région,
- formation d'au moins un premier moyen de polarisation de la première portion de la deuxième région adapté pour modifier la répartition des porteurs d'au moins un type de conductivité dans la première portion par rapport à la première et à la deuxième zone de confinement.

Un tel procédé de fabrication permet de fournir une structure dans laquelle il est possible de moduler la répartition de l'émission entre chacune des zones de confinement.

L'invention concerne également un dispositif semiconducteur comportant une pluralité de structures semiconductrices destinées à émettre de la lumière, le dispositif comportant au moins une structure semiconductrice selon l'invention.

Il est possible de faire varier l'émission de chacune des structures qui sont selon l'invention pour fournir une surface d'affichage variable telle que par exemple celle d'un écran. On évite ainsi la nécessité de devoir faire appel à plusieurs structures, chacune dédiée à une couleur, pour obtenir une variation de la lumière émise.

### BRÈVE DESCRIPTION DES DESSINS

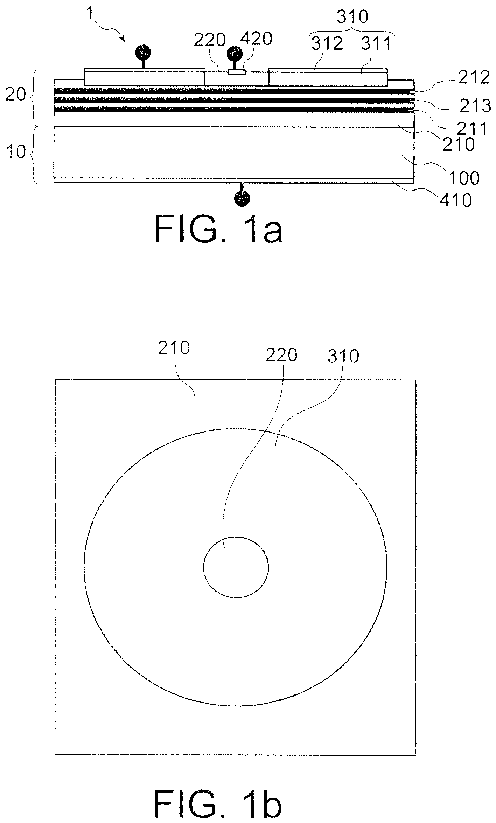

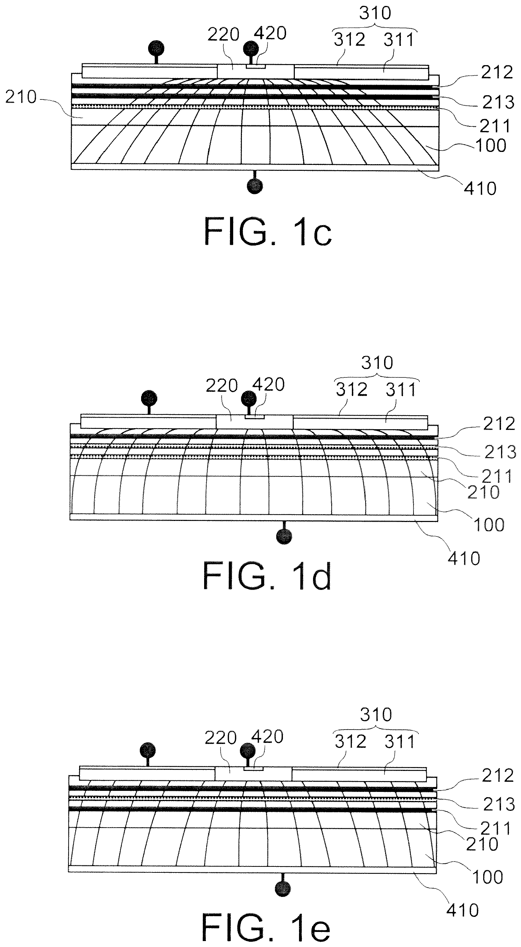

La présente invention sera mieux comprise à la lecture de la description d'exemples de réalisation, donnés à titre purement indicatif et nullement limitatif, en faisant référence aux dessins annexés sur lesquels :
- les figures la à le illustrent un exemple de structure semiconductrice avec son principe de fonctionnement selon un premier mode de réalisation de l'invention, les figures 1a et 1b illustrant respectivement une vue en coupe et de dessus de la structure, les figures 1c à le illustrant respectivement une vue en coupe en fonctionnement dans lesquelles l'émission a lieu dans respectivement une première zone de confinement, une première et une deuxième zone de confinement ,et une deuxième zone de confinement,
- les figures 2a à 2d illustrent la variation de la puissance émise, notée P_{L}, dans chacune des zones de confinement de la structure illustrée sur la figure 1 pour quatre valeurs de polarisation du premier moyen de polarisation,
- la figure 3 illustre une structure selon un deuxième mode de réalisation dans laquelle il est prévu trois zones de confinement adaptées pour émettre à trois longueurs d'onde différentes et dans lequel la ou les zones de confinement dans laquelle ou lesquelles a lieu l'émission sont sélectionnées au moyen d'un premier moyen de polarisation,
- les figures 4a et 4b illustrent la variation de la puissance émise, notée P_{L}, dans chacune des zones de confinement de la structure illustrée sur la figure 3 pour deux valeurs de polarisation du premier moyen de polarisation,
- les figures 5a à 5d illustrent un procédé de fabrication d'une structure telle qu'illustrée sur la figure 3,
- les figures 6a et 6d illustrent un procédé de fabrication d'une structure selon une possibilité de variante du deuxième mode de réalisation,
- les figures 7a et 7b illustrent chacune une structure selon un troisième mode de réalisation dans laquelle il est en outre prévu un deuxième moyen de polarisation afin de parfaire la sélection de la ou des zones de confinement dans laquelle ou lesquelles a principalement lieu l'émission, le premier et le deuxième moyen de polarisation étant prévus respectivement, pour la figure 7a et la figure 7b, sur repectivement des faces opposées et la même face de la structure,
- les figures 8a et 8b illustrent la variation de la puissance émisse, notée P_{L}, dans chacune des zones de confinement de la structure illustrée sur la figure 7a pour deux valeurs de polarisation du premier et du deuxième moyen de polarisation,
- les figures 9a à 9e illustrent un procédé de fabrication d'une structure selon une possibilité de variante au troisième mode de réalisation.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

La figure 1 illustre une structure 1 semiconductrice destinée à émettre de la lumière qui, comportant plusieurs zones de confinement dans lesquelles l'émission de lumière peut avoir lieu, est adaptée pour permettre la sélection et la commutation de la ou les zones de confinement dans lesquelles l'émission de lumière a lieu.

Si une telle structure selon l'invention peut être adaptée, en fonction des matériaux la composant, pour émettre de la lumière dans une gamme pouvant aller des ultra-violets profonds aux infrarouges lointains, il est décrit ci-dessous une application particulière de l'invention dans laquelle la structure est adaptée pour émettre dans une gamme de longueurs d'onde du visible. Ainsi, les valeurs et les matériaux indiqués ci-dessous et dans le reste de ce document, quand cela est précisé, concernent uniquement l'application particulière et ne limitent donc en rien la portée de l'invention.

Une telle structure 1 selon un premier mode de réalisation de l'invention comporte :
- un support 100 semiconducteur formant une première région 10 semiconductrice d'un premier type de conductivité,
- une deuxième région 20 semiconductrice en contact avec le support 100, ladite deuxième région 20 comportant une première portion 210 du type non intentionnellement dopé, comprenant trois zones de confinement 211, 212, 213, et une deuxième portion 220 d'un deuxième type de conductivité opposé au premier type de conductivité, la première et la deuxième portion 210, 220 étant agencées par rapport à la première région 10 de manière à former avec cette dernière une jonction semiconductrice s'étendant principalement dans la première portion 210,

- un premier et un deuxième contact électrique 410, 420 adaptés pour connecter électriquement respectivement la première et la deuxième région 10, 20,
- une première grille de polarisation agencée pour soumettre directement la première portion 210 à une première polarisation extérieure et ainsi modifier la répartition des porteurs du premier et du deuxième type de conductivité dans la première portion 210 par rapport aux zones de confinement 211,212, 213.

Le support 100, tel qu'illustré sur la figure 1a, est un support semiconducteur sensiblement plan présentant une première et une deuxième face. Le support 100 est réalisé dans un matériau semiconducteur préférentiellement à gap direct tel que le nitrure de galium GaN ou du nitrure de zinc ZnO. Le support 100 présente le premier type de conductivité.

On entend par « matériau semiconducteur à gap direct » que le matériau semiconducteur présente son maximum d'énergie de la bande de valence et son minimum d'énergie de la bande de conduction qui se situent à des valeur du vecteur d'onde k sensiblement égales dans le diagramme de dispersion énergétique dudit matériau semiconducteur.

Dans l'application particulière, le support 100 est un support en nitrure de gallium GaN. Selon cette même application, le premier type de conductivité est un type de conductivité dans lequel les porteurs majoritaires sont des électrons. Le support 100 présente dans l'application particulière une concentration en porteurs majoritaires supérieure ou égale à 10¹⁸ cm⁻³.

La deuxième région 20 est en contact avec le support, et donc avec la première région 10, sur sa deuxième face au moyen de la première portion 210 de la deuxième région 20.

La première portion 210, telle qu'illustrée sur la figure 1a, est une couche semiconductrice sensiblement plane qui s'étend le long de la deuxième face du support 100. La première portion 210 comporte un plan de couche et une première et une deuxième face, la première portion 210 étant en contact avec le support 100 sur sa première face.

La première portion 210 est principalement réalisée dans un matériau semiconducteur à gap direct avec les zones de confinement 211, 212, 213 qui sont réalisées dans au moins un autre matériau semiconducteur à gap direct. La première portion est préférentiellement du type non intentionnellement dopé de manière à ce que la jonction s'étende sur la totalité de l'épaisseur de la première portion. Selon cette possibilité la concentration en porteurs majoritaires peut être de l'ordre de 10¹⁶ cm⁻³. On peut noter qu'en variante à une première portion du type non intentionnellement dopé cette dernière peut être du premier type de conductivité ou d'un deuxième type de conductivité opposé au premier type de conductivité.

Dans l'application particulière, la première portion est principalement réalisée dans du nitrure de gallium GaN. Selon cette même application particulière, la première portion est du premier type de conductivité avec une concentration en porteurs majoritaires qui est sensiblement égale à 10¹⁸ cm⁻³.

La première portion 210 comporte la première, la deuxième et la troisième zone de confinement 211, 212, 213. Chacune des zones de confinement 211, 212, 213 est formée par une sous-couche de la première portion 210. Ainsi, la première zone 211 de confinement est formée par une sous-couche qui s'étend selon le plan de couche de la première portion en regard de la première face de la première portion tandis que la deuxième zone 212 de confinement est en regard de la deuxième face de la première portion 210. La troisième zone de confinement 213, est formée par une sous couche qui s'étend également, de la même manière que celles formant la première et la deuxième zone de confinement 211, 212, selon le plan de couche de première portion 210 en étant positionnée entre la première et la deuxième zone de confinement 211, 212. L'épaisseur de chacune des zones de confinement est comprise entre 1 et 10 nm, la distance entre deux zones successives étant du même ordre de grandeur.

Selon une première possibilité de l'invention, dans laquelle ce sont les capacités de forte émission de l'invention qui sont particulièrement recherchées, la première, la deuxième et la troisième zone de confinement 211, 212, 213 peuvent être réalisées dans le même matériau et présenter les même caractéristiques dimensionnelles.

Selon une deuxième possibilité de l'invention, dans laquelle ce sont les capacités de l'invention à fournir une longueur d'onde d'émission variable qui sont recherchées, la première, la deuxième et la troisième zone de confinement 211, 212, 123 peuvent être réalisées dans des matériaux différents et/ou présenter des caractéristique dimensionnelles différentes les unes des autres de manière à présenter dans chacune des trois zones de confinement 211, 212, 123 des longueurs d'onde d'émission différentes.

Selon cette deuxième possibilité et selon l'application particulière, la première, la deuxième et la troisième zone 211, 212, 123 sont respectivement adaptées pour émettre sensiblement dans le violet (longueur d'onde d'environ 420 nm), le vert (longueur d'onde d'environ 480 nm) et le jaune (longueur d'onde d'environ 530 nm) de manière que leur longueurs d'onde d'émission soient réparties dans la gamme de longueurs d'onde du visible. A cet effet, la première, la deuxième et la troisième zone 211, 212, 213 peuvent être réalisées dans un nitrure d'indium et gallium InₓGa₁₋ₓN avec une proportion d'indium respective par exemple de 10%, 30% et 20%. Dans cette application particulière, l'épaisseur des zones de confinement 211, 212, 213 est sensiblement identique et comprise entre 1 et 10 nm avec un espace du même ordre de grandeur entre deux zones de confinement consécutives.

La première portion 210 est en contact, sur une partie de sa deuxième face, avec la deuxième portion 220 de la deuxième région.

La deuxième portion 220 de la deuxième région 20, telle qu'illustrée sur les figures 1a et 1b, prend la forme d'un plot cylindrique dont la base est en contact avec la première portion 210 sur sa deuxième face. La deuxième portion 220 est réalisée dans un matériau semiconducteur préférentiellement à gap direct. La deuxième portion 220 présente un deuxième type de conductivité opposé au premier type de conductivité. Les dimensions latérales de la deuxième portion 220, selon le principe de fonctionnement de ce premier mode de réalisation, peuvent être faibles vis-à-vis de celles de la première portion 210.

Dans l'application particulière, la deuxième portion 220 de la deuxième région est réalisée en nitrure de gallium GaN. La deuxième portion 220 est du deuxième type de conductivité qui est opposé au premier type de conductivité, c'est-à-dire du type de conductivité pour lequel les porteurs majoritaires sont des trous.

La partie de la deuxième face de la première portion 210 qui n'est pas recouverte par la deuxième portion 220 est en contact avec la grille de polarisation 310. Dans une telle configuration, la grille de polarisation est à proximité de la deuxième portion 220 par rapport à la première région 10.

De cette manière, la deuxième portion 220 de la deuxième région 20 et la grille de polarisation 310 sont agencés de manière complémentaire sur la deuxième face de la première portion 210.

La grille de polarisation 310 comporte une couche isolante 311 et une couche conductrice 312.

La couche isolante 311 recouvre la partie de la deuxième face de la première portion 210 qui n'est pas recouverte par la deuxième portion 220. La couche isolante 311 est réalisée dans un matériau isolant électriquement, tel que le dioxyde de silicium SiO₂, le dioxyde d'hafnium HfO₂, ou un autre matériau à haute constante diélectrique (connus sous leur dénomination anglaise de « high k »). La couche isolante 311 présente une épaisseur comprise entre 1 à 10 nm de manière à isoler électriquement la couche conductrice 312 de la première portion 210.

Dans l'application particulière, la couche isolante 311 est réalisée en dioxyde d'hafnium HfO₂.

La couche conductrice 312 recouvre la couche isolante 311 de manière à ce qu'une polarisation de cette dernière entraîne une modification de la répartition des porteurs du deuxième type de conductivité dans la première portion 210 de manière à obtenir dans la première portion une accumulation ou une déplétion de porteurs du deuxième type de conductivité.

La couche conductrice 312 est préférentiellement adaptée pour être transparente à la lumière émise par la structure 1 de manière à laisser s'échapper la lumière de la structure 1 après qu'elle soit émisse. Ainsi selon cette possibilité, comme cela est le cas dans l'application particulière, la couche conductrice peut être réalisée dans un oxyde d'indium et d'étain plus connu sous son sigle anglais ITO.

Le support 100 et la deuxième portion 220 sont tous deux équipés d'un contact électrique 410, 420 respectif adapté, ceci de manière à former une diode électroluminescente. Les contacts électriques 410, 420 sont tous deux adaptés pour former un contact ohmique avec la région 10 et/ou portion 220 qu'il équipe.

Ainsi, dans l'application particulière le premier contact 410 qui est en contact avec le support 100 est adapté pour former un contact ohmique avec un nitrure de gallium GaN dont le type de conductivité est celui pour lequel les porteurs majoritaires sont des électrons, tandis que le deuxième contact 420 qui est en contact avec la deuxième portion 220 de la deuxième région 20 est adapté pour former un contact ohmique avec un nitrure de gallium GaN dont le type de conductivité est celui pour lequel les porteurs majoritaires sont des trous.

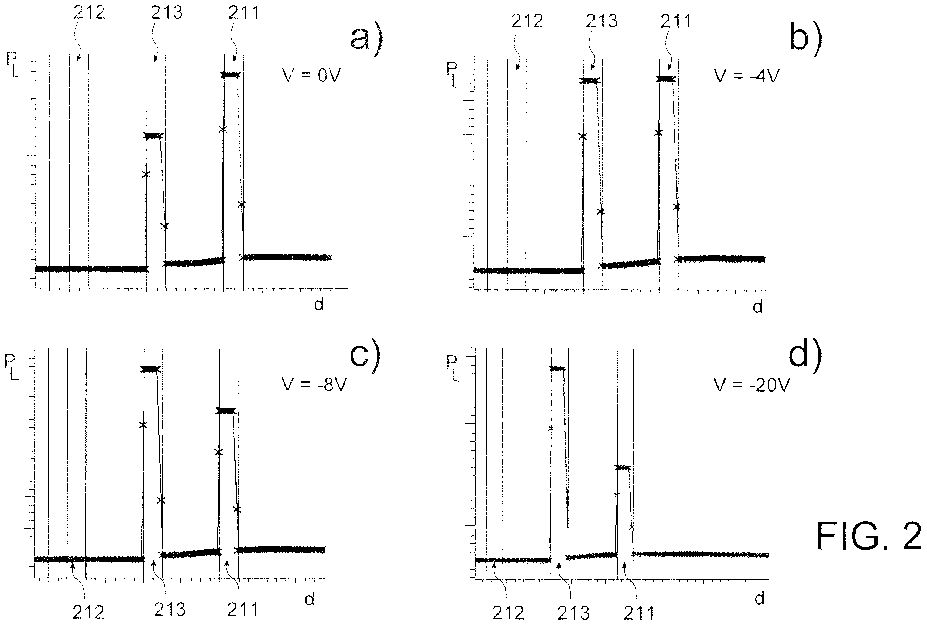

Les figures 1c à 1e, ainsi que les figures 2a à 2d, illustrent le principe de fonctionnement d'une telle structure lorsqu'elle est selon l'application particulière.

Ainsi, la figure 1c illustre le fonctionnement de la structure lorsqu'aucune tension de polarisation n'est appliquée sur la première grille de polarisation 310. Dans cette configuration, alors que la diode formée par la première et la deuxième région 10, 20 est polarisée positivement, en l'absence de polarisation appliquée sur la première grille de polarisation 310 cette dernière n'influence pas la première portion 210 de la deuxième région 20. On est donc dans la configuration d'une diode de l'art antérieur et l'émission a lieu principalement dans la première zone de confinement 211. Lorsque la première grille de polarisation 310 est polarisée négativement relativement à la tension appliquée sur le deuxième contact 420, la tension de polarisation de la première grille de polarisation 310 modifie la répartition des lignes de courant en créant un étalement des lignes de courant. Cette modification de la répartition des lignes de courant permet de modifier la répartition des porteurs majoritaires du deuxième type de conductivité en créant une accumulation de ces derniers comme l'illustrent les figures 1d et 1e.

Ainsi, en l'absence de tension appliquée sur la première grille de polarisation 310, la distribution des lignes de courant favorise les recombinaisons radiatives dans la première zone de confinement 211. Lors de l'application d'une tension négative sur la première grille de polarisation 310, l'étalement des lignes de courant qui en résulte permet d'augmenter le volume de la troisième zone de confinement 213 dans lequel à lieu les recombinaisons paires électron-trou pour dans un premier temps, comme illustré sur la figure 1d, égaliser l'émission dans la première et la troisième zone de confinement 211, 213 et pour, dans un deuxième temps et des tensions négatives plus fortes, rendre l'émission dans la troisième zone de confinement 213 prépondérante.

Les simulations, illustrées graphiquement sur les figures 2a à 2d, montrent ce phénomène en illustrant la variation de la puissance lumineuse émise P_{L} le long de la hauteur d de la structure 1. En effet, on peut voir que pour une polarisation de 0 V appliquée sur la première grille de polarisation 310, environ 60 % de la puissance lumineuse P_{L} émise l'est à partir de la première zone 211. Lorsque la tension de polarisation de la première grille de polarisation 310 est mise à -4V, comme cela est illustré sur la figure 2b, la puissance émise est sensiblement équitablement répartie entre la première zone de confinement 211 et la troisième zone de confinement 213.

L'émission devient prépondérante dans la troisième zone de confinement pour atteindre environ 66% de la puissance lumineuse émise pour une tension de la première grille de polarisation 310 de -20 V.

Ainsi, selon l'application particulière, on passe d'une lumière d'émission tirant vers le jaune à une lumière d'émission tirant sur le vert.

Un procédé de fabrication d'une structure 1 selon ce premier mode de réalisation et l'application particulière peut comporter les étapes suivantes :
- fourniture d'un support 100 semiconducteur du premier type de conductivité pour lequel les porteurs majoritaires sont les électrons, ledit support 100 étant réalisé en nitrure de gallium GaN,
- formation de la première portion 210 de la deuxième région 20 en déposant une couche de nitrure de gallium GaN du premier type de conductivité, lors de cette formation de l'indium In étant rajouté au nitrure de gallium GaN de manière à former les zones de confinement 211, 212, 213,

- formation d'une couche de nitrure de gallium GaN en contact avec la première portion 210 de la deuxième région 20,
- gravure d'une partie de la couche de nitrure de gallium de manière à laisser un unique plot cylindrique en surface de la première portion 210 et ainsi former la deuxième portion 220 de la deuxième région 20 et donc, avec la première portion 210, la deuxième région 20,
- formation d'une couche de dioxyde d'hafnium HfO₂ sur la surface de la première portion 210 de la deuxième région 20 qui n'est pas recouverte par la deuxième portion 220 de manière à former la couche isolante 311,
- formation d'une couche conductrice 312 en contact avec la couche isolante 311, ladite couche conductrice 312 étant réalisée en oxyde d'indium et d'étain, ladite couche conductrice 312 formant avec la couche isolante 311 la première grille de polarisation 310,
- formation du premier et du deuxième contact électrique 410, 420 en contact respectivement avec le support 100 et la deuxième portion 220 de la deuxième région 20.

Selon une autre possibilité de l'invention, le procédé de fabrication d'une structure 1 selon ce premier mode de réalisation peut comporter en lieu et place des deux étapes de fabrication de la deuxième portion 220 de la deuxième région 20 consistant à former une couche de nitrure de gallium GaN et à en graver une partie de manière à former un plot, les trois étapes suivantes de :
- formation d'un masque laissant libre uniquement la partie de la deuxième face de la première portion 210 qui est destinée à être en contact avec la deuxième portion 220 de la deuxième région 20,
- formation de la deuxième portion 220 en déposant sélectivement du nitrure de gallium GaN en contact avec la partie de deuxième face de la première portion 210 de la deuxième région 20 qui n'est pas protégée par le masque,
- suppression du masque.

De telles structures 1 peuvent équiper un dispositif semiconducteur, non illustré, ceci de manière que ce dernier forme un dispositif d'affichage d'information tel qu'un écran. Dans un tel dispositif, les structures 1 selon l'invention, dont l'émission peut être modulée indépendamment les unes des autres, peuvent être organisées en ligne et en colonne.

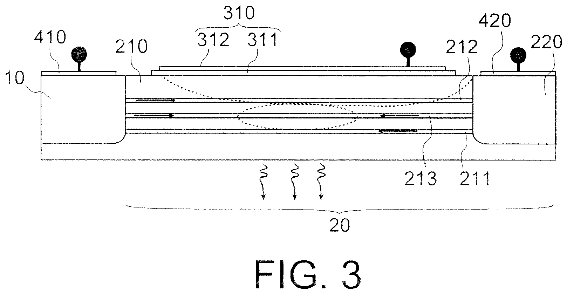

La figure 3 illustre une structure 1 selon un deuxième mode de réalisation dans lequel la structure 1 est une structure du type planaire.

Une structure 1 selon ce deuxième mode réalisation se différencie d'une structure 1 selon le premier mode de réalisation en ce que la première et la deuxième région 10, 20 se présentent dans une seule couche, dite couche active en contact avec ou sans support 100, ce dernier, lorsque la structure 1 en comporte un, ne faisant donc pas office de première région.

On peut noter que dans ce deuxième mode de réalisation, une structure 1 selon l'application particulière présente un premier et un deuxième type de conductivité inversés par rapport à ceux d'une structure selon le premier mode de réalisation lorsqu'elle est selon l'application particulière. Ainsi, dans ce deuxième mode de réalisation et selon l'application particulière, le premier type conductivité est celui pour lequel les porteurs majoritaires sont des trous, le deuxième type de conductivité étant celui pour lequel les porteurs majoritaires sont des électrons.

Le support 100, selon ce deuxième mode de réalisation et lorsque la structure 1 en comporte, se différencie d'un support 100 selon le premier mode de réalisation en ce qu'il peut être réalisé dans un matériau autre qu'un matériau semiconducteur, tel que par exemple du saphir Al₂O₃ et en ce qu'il n'est pas nécessairement du premier type de conductivité, les propriétés de conduction de ce dernier n'étant pas exploitées pour le fonctionnement de la structure 1. Selon la possibilité illustrée sur la figure 3, la structure 1 ne comporte pas de support 100.

Dans l'application particulière, la structure 1 ne comporte pas de support 100, et la première portion 210 de la deuxième région 20 est réalisée en nitrure de gallium GaN de type non intentionnellement dopé.

Dans ce deuxième mode de réalisation, la première région 10 et la deuxième portion 220 de la deuxième région 20 sont toutes deux des parties latérales de la couche active et la première portion 210 de la deuxième région est une partie centrale de cette même couche active. La première portion 210 fait interface entre la première région 10 et la deuxième portion 220 de la deuxième région 20.

La première portion 210 s'étend longitudinalement selon le plan de couche de la couche active et comporte une première et une deuxième face longitudinale. Dans ce deuxième mode de réalisation les première, deuxième et troisième zones de confinement 211, 212, 213 s'étendent toutes trois selon le plan de couche. La première zone de confinement 211 est en regard de la première face tandis que la deuxième zone de confinement 212 est en regard de la deuxième face de la première portion 210. La troisième zone de confinement 213 est positionnée entre la première et la deuxième zone de confinement 211, 212.

Dans ce deuxième mode de réalisation, la première grille de polarisation 310 formée de la couche isolante 311 et de la couche conductrice 312, recouvre la deuxième face de la première portion 210 de la deuxième région 20. Le premier et le deuxième contact électrique 410, 420 sont présents sur une même face de la couche active qui est celle sur laquelle affleurent la première région 10 et la deuxième portion 220 de la deuxième région 20. Avec un tel agencement de la première grille de polarisation 310, cette dernière est à proximité de la première région 10 et de la deuxième portion 220 de la deuxième région 20. Ainsi, la première grille de polarisation est sensiblement à équidistance de la première région 10 et de la deuxième portion 220.

Selon l'application particulière le premier et le deuxième contact 410, 420 sont respectivement adaptés pour former un contact ohmique avec la première région 10 et la deuxième portion 220 de la deuxième région 20

Le principe de fonctionnement d'une structure 1 selon ce deuxième mode de réalisation se différencie du principe de fonctionnement d'une structure 1 selon le premier mode de réalisation en ce que l'application d'une tension de polarisation influence à la fois la répartition ses porteurs du premier et du deuxième type de conductivité avec pour une tension positive une accumulation d'électrons et pour une tension négative une accumulation de trous. Ainsi, il est possible avec une telle électrode de modifier les lignes de courant et donc la répartition de l'émission entre les différentes zones de confinement 211, 212, 213.

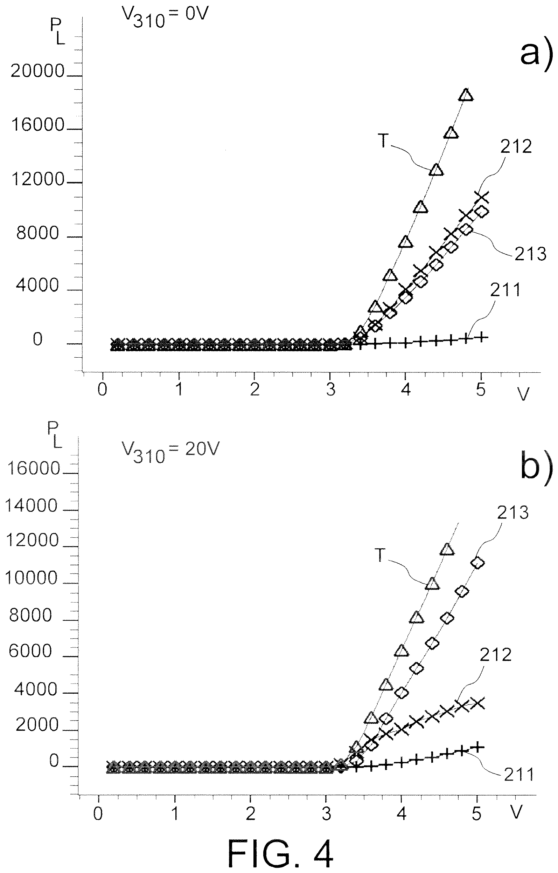

Les résultats de simulations qui sont illustrées sur les figures 4a et 4b, montrent ce phénomène. En effet, on peut voir sur la figure 4a que pour une polarisation de 0 V appliquée sur la première grille de polarisation 310, la puissance lumineuse émise est similaire entre la deuxième et la troisième zone de confinement 211, 212. Lorsque la tension de polarisation de la première grille de polarisation 310 est mise à 20 V, comme cela est illustré sur la figure 4b, la puissance émise a principalement pour origine la troisième zone de confinement 213 la proportion de la puissance lumineuse émise par la première et la deuxième zone de confinement 211, 212 représentant moins de 33% de la totalité de la puissance lumineuse émise T. En effet, une tension de polarisation de la première grille de polarisation 310 positive relativement à la première région 10 et à la deuxième portion 220 de la première région 20, entraîne une accumulation d'électrons. Il en résulte une inhibition partielle de l'émission de lumière dans la deuxième zone de confinement 212, l'émission devenant prépondérante dans la troisième zone de confinement 213.

On peut noter qu'en variante, une polarisation négative de la première grille de polarisation 310 permet de créer une accumulation de trous dans la deuxième zone de confinement 212 en entraînant des effets similaire à ceux expliqués ci-dessus.

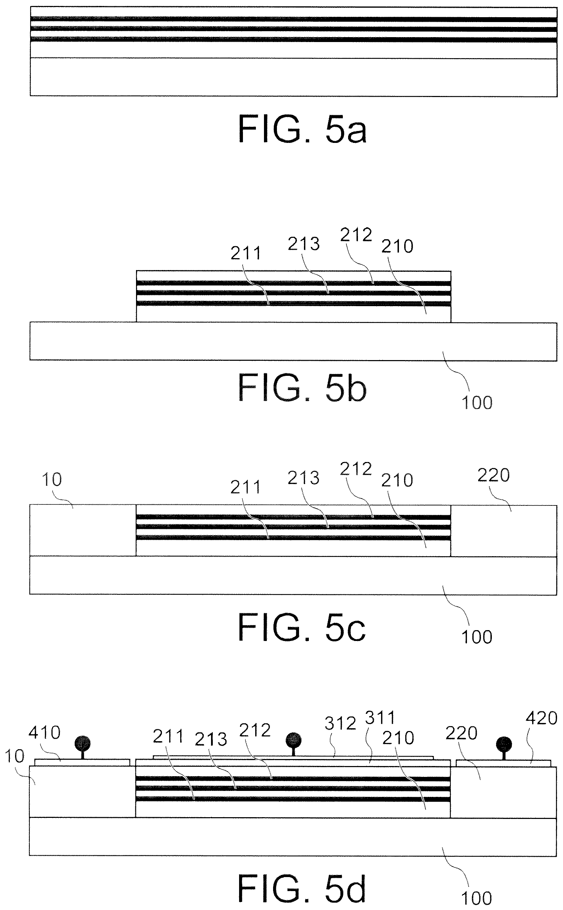

Les figures 5a à 5c illustrent les principales étapes d'un procédé de fabrication d'une structure 1 selon ce deuxième mode de réalisation. Un tel procédé de fabrication, lorsqu'il s'agit d'un procédé de fabrication d'une structure 1 selon l'application particulière, comporte les étapes suivantes :
- fourniture, comme illustré sur la figure 5a, d'une couche de nitrure de gallium GaN du type non intentionnellement dopé, de l'indium In ayant été ajouté dans le nitrure de gallium lors de la formation de la couche de manière à former les première, deuxième et troisième zones de confinement 211, 212, 213,
- gravure, comme illustré sur la figure 5b, d'une partie de la couche de nitrure de gallium GaN de manière à libérer deux parties latérales de ladite couche correspondant respectivement à la première région 10 et la deuxième portion 220 de la deuxième région 20, ladite étape de gravure permettant de définir la première portion 210 de la deuxième région 20,
- formation d'une zone de nitrure de gallium GaN du premier type de conductivité de l'une des parties libérées lors de l'étape de gravure de manière à former la première région 10,
- formation d'une zone de nitrure de gallium GaN du deuxième type de conductivité de la partie des deux parties latérales libérées lors de l'étape de gravure sur laquelle la première région 10 n'a pas été formée de manière à former la deuxième portion 220 de la deuxième région 20, cette dernière étape, comme cela est illustré sur la figure 5c, permettant de former la couche active et la deuxième région 20,
- formation de la couche isolante 311 en contact avec la première portion 210 de la deuxième région 20,
- formation de la couche conductrice 312 en contact avec la couche isolante 311 de manière à former la première grille de polarisation 310,
- formation du premier et du deuxième contact électrique 410, 420 en contact respectivement de la première région 10 et de la deuxième portion 220 de la deuxième région 20, comme cela est illustré sur la figure 5d.

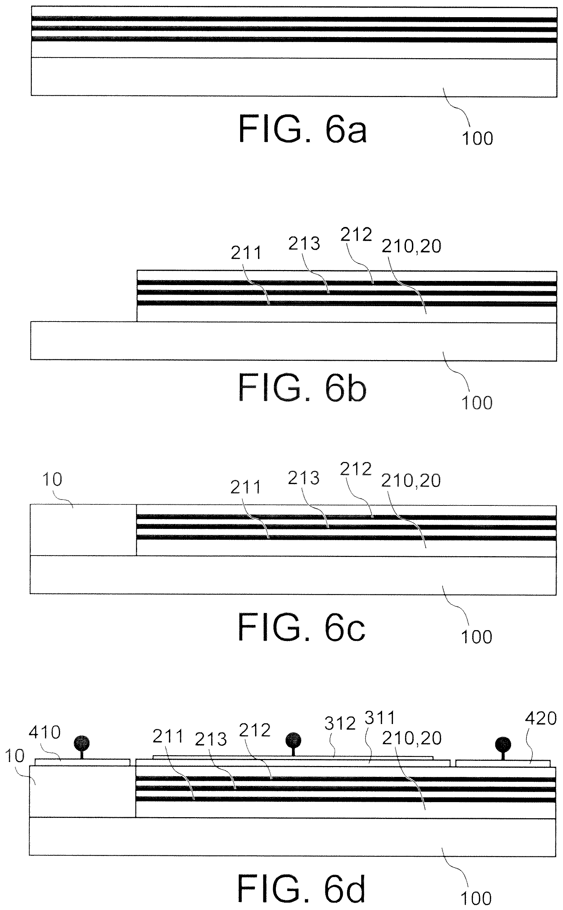

Les figures 6a à 6d illustrent un procédé de fabrication d'une structure 1 selon une variante du deuxième mode de réalisation.

Une structure 1 selon cette variante du deuxième mode de réalisation se différencie d'une structure selon le deuxième mode de réalisation décrit ci-dessus en ce que, comme illustré sur la figure 6d, la deuxième région 20 comporte uniquement la première portion 210, cette dernière étant du deuxième type de conductivité.

Ainsi selon cette variante, la première portion 210 présente le deuxième type de conductivité de manière à ce que cette dernière forme une portion du deuxième type de conductivité de la deuxième région 20.

Ainsi, dans l'application particulière la première portion 210 est réalisée dans un nitrure de gallium GaN du deuxième type de conductivité, c'est-à-dire du type de conductivité pour lequel les porteurs majoritaires sont des trous. La concentration en porteurs majoritaires de la première portion 210 peut être de 10¹⁸ cm⁻³.

La première portion 210 est équipée, à l'opposé de la première région 10, du deuxième contact électrique 420.

Le principe de fonctionnement d'une structure 1 selon cette variante au deuxième mode de réalisation est identique à celui d'une structure 1 selon le deuxième mode de réalisation déjà expliqué, à la différence que lorsque la première grille de polarisation 310 est polarisée de manière à créer une accumulation du deuxième type de conductivité, les porteurs majoritaires sont issus de cette même première portion 210.

Un procédé de fabrication d'une structure 1 selon cette variante du deuxième mode de réalisation, tel qu'illustré sur les figures 6a à 6d se différencie du procédé de fabrication selon le deuxième mode de réalisation déjà décrit en ce que lors de l'étape de formation de la couche de nitrure de gallium GaN du type non intentionnellement dopé, cette dernière est réalisée dans un nitrure de gallium GaN du deuxième type de conductivité, en ce que pendant l'étape de gravure, comme cela est illustré sur la figure 6b, seule une partie latérale de la couche de nitrure de gallium GaN est gravée, celle correspondant à la première région 10, et en ce qu'il n'est pas prévu une étape de formation de la deuxième portion 220 de la deuxième région 20, la structure 1 n'en comprenant pas.

On peut également noter, comme cela est illustré sur la figure 6d, que lors de l'étape de formation des contacts électriques 410, 420, le deuxième contact électrique 420 est formé en contact avec la première portion 210 de la deuxième région 20 sur une partie latérale de cette dernière, la première grille de polarisation 310 présentant ainsi une position centrale par rapport aux deux contacts électriques 410, 420.

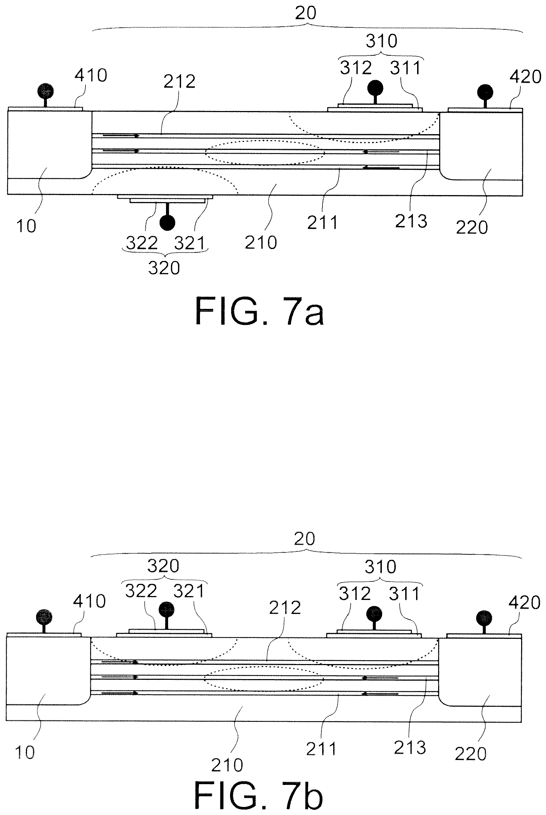

La figure 7a illustre une structure 1 selon un troisième mode de réalisation de l'invention dans lequel il est prévu une deuxième grille de polarisation 320. Une structure 1 selon ce troisième mode de réalisation se différencie d'une structure selon le deuxième mode de réalisation en ce qu'elle comporte en outre une deuxième grille de polarisation 320. Cette deuxième grille de polarisation 320 est adaptée pour qu'une polarisation de cette dernière entraîne une modification de la répartition des porteurs du premier type de conductivité.

L'accumulation de porteurs majoritaires du premier type de conductivité dans la première portion 210 est obtenue à partir de la première région 10.

De même que pour la deuxième mode de réalisation et comme cela est illustré sur la figure 7, une structure 1 selon ce troisième mode de réalisation ne comporte pas de support 100, la première portion 210 de la deuxième région 20 formant la majeure partie de la structure 1.

Dans ce troisième mode de réalisation, la première grille de polarisation 310 est en contact avec la première portion 210 de la deuxième région à proximité de la deuxième portion 220 de la deuxième région 20. La deuxième grille de polarisation 320 est en contact avec la première portion 210 à proximité de la première région. La deuxième grille de polarisation 320 est positionnée sur la face de la première portion 210 qui est opposée à la première grille de polarisation 310.

La deuxième grille de polarisation 320, présente une configuration similaire à celle de la première grille de polarisation 310. Ainsi la deuxième grille de polarisation 320 comporte une couche d'isolation 321 en contact avec la première portion 210 et une couche de conduction 322 en contact avec la couche d'isolation 321.

La deuxième grille de polarisation 320 forme un moyen de polarisation agencé pour polariser la première portion 210 et pour qu'une polarisation de la deuxième grille de polarisation 320 entraîne une modification de la répartition des porteurs majoritaires du premier type de conductivité dans la première portion 210.

Le principe de fonctionnement d'une structure 1 selon ce troisième mode de réalisation est d'utiliser la première et la deuxième grille de polarisation 310, 320 pour modifier respectivement la répartition des porteurs du deuxième et du premier type de conductivité. Ainsi, dans ce troisième mode de réalisation, la première grille de polarisation 310 permet, lors de l'application d'une tension, de modifier la répartition des porteurs du deuxième type de conductivité et de générer dans la première portion 210 soit une zone de déplétion, soit une zone d'accumulation de porteurs du deuxième type conductivité. De manière similaire la deuxième grille de polarisation 320 permet de modifier la répartition des porteurs du premier type de conductivité et de générer dans la première portion 210 soit une zone de déplétion, soit une zone d'accumulation de porteurs du premier type de conductivité. Il est donc possible, en modulant la polarisation de la première et de la deuxième grille de polarisation 310, 320, de moduler la répartition des porteurs du premier et du deuxième type de conductivité, et donc la répartition des lignes de courant entre la première, la deuxième et la troisième zone de confinement 211, 212, 213. Une telle modification permet de moduler l'émission, entre la première, la deuxième et la troisième zone de confinement 211, 212, 213

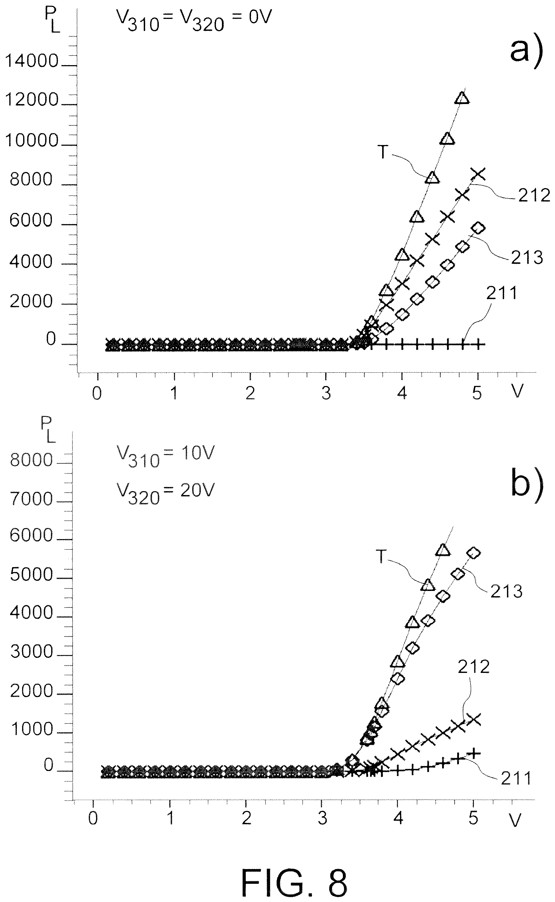

Les simulations d'une telle structure 1, dont les graphiques sont présents sur les figures 8a à 8b, illustrent ce principe pour une structure 1 selon l'application particulière. En effet, lorsqu'aucune polarisation n'est appliquée sur les grilles de polarisation 310, 320, comme illustré sur la figure 8a, la puissance lumineuse est fournie à la fois dans la deuxième et la troisième zone de confinement 212, 213. En effet, ces deux zones de confinement comportant une largeur de bande interdite les plus faible, ce sont ces deux zones de confinement qui sont le plus propice au passage du courant entre la première région 10 et la deuxième portion 220.

Pour une tension de 10 V appliquée sur la première grille de polarisation 310 et une tension de 20 V appliquée sur la deuxième grille de polarisation 320, la puissance lumineuse est cette fois principalement émise dans la troisième zone de confinement 213 qui représente environ 70% de la puissance totale émisse, la puissance émise dans la première et la deuxième zone de confinement 211, 212 correspondant respectivement à environ 10% et 20% de la puissance totale émise.

Dans cette configuration, la tension de 10V appliquée sur la première grille de polarisation 310 permet de générer au voisinage de cette dernière, et donc au niveau de deuxième zone de confinement, une zone de déplétion pour les porteurs du premier type de conductivité, c'est-à-dire les trous. Une telle zone de déplétion réduit donc le nombre de recombinaisons paires électron-trou ayant lieu dans la deuxième zone de confinement 212. La tension de 20 V appliquée sur la deuxième grille de polarisation 320 permet de générer une accumulation du deuxième type de porteurs, c'est-à-dire les électrons, au voisinage de la grille de polarisation et donc dans la première zone de confinement 211 et en partie dans la troisième zone de confinement 213. Un tel apport d'électrons dans la troisième zone de confinement 213 permet d'augmenter la probabilité de rencontre entre les électrons et les trous et de recombinaisons paires électron-trou. Il en résulte une augmentation de la puissance lumineuse émise dans la troisième zone de confinement 213. Cette accumulation permet également, dans une moindre mesure, d'augmenter la puissance émise dans la première zone de confinement 210.

La figure 7b, illustre une structure selon une variante de réalisation d'une structure selon le troisième mode de réalisation dans lequel la deuxième grille de polarisation 320 est agencée sur la même face que celle sur laquelle est agencée la première grille de polarisation 310. La deuxième grille de polarisation, selon cette variante, est également à proximité de la première région 10.

Le principe de fonctionnement est identique à celle de la structure 1 selon le deuxième mode de réalisation déjà décrit si ce n'est que pour obtenir les mêmes effets la tension polarisation de la deuxième grille de polarisation 320 doit être inversée. En effet, dans ce deuxième mode de réalisation, la deuxième grille de polarisation 320 étant agencée au voisinage de la deuxième zone de confinement, pour créer une zone d'accumulation d'électrons au niveau de la première zone de confinement il est nécessaire de générer une zone de déplétion d'électrons au niveau de la deuxième zone de confinement 212. Donc, les résultats illustrés sur la figure 8b peuvent être obtenus dans une telle structure par une application d'une tension positive sur la première grille de polarisation 310 et négative sur la deuxième grille de polarisation 320.

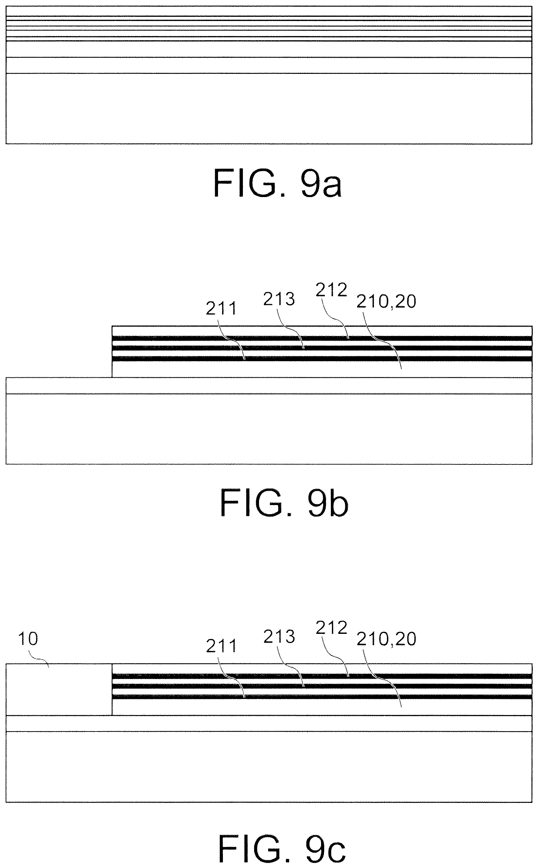

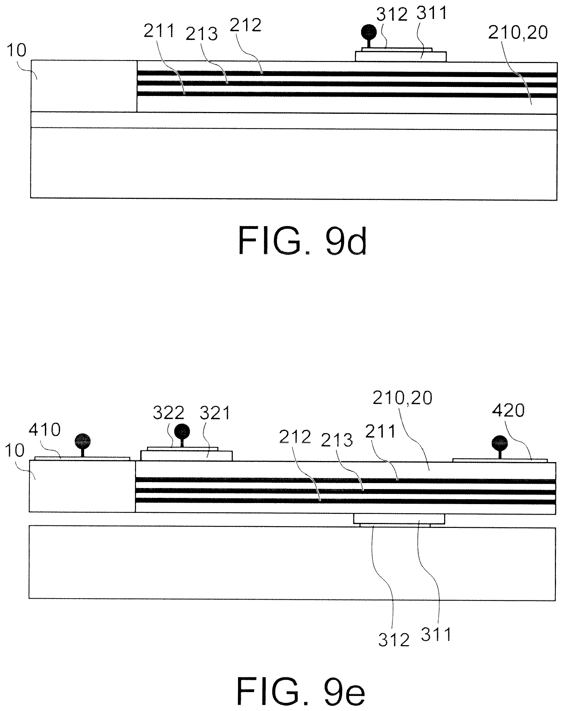

Les figures 9a à 9e illustrent un procédé de fabrication d'une structure selon ce troisième mode de réalisation dans sa variante illustrée sur la figure 7a selon une possibilité de l'invention dans laquelle la deuxième région 20 ne comporte pas de deuxième portion 220, la première portion 210 étant du deuxième type de conductivité. Selon cette possibilité, la structure 1, comme cela est illustré sur la figure 9e, est en contact avec un substrat conducteur au moyen de la première grille de polarisation 310.

Un tel procédé de fabrication comporte les étapes suivantes :
- fourniture d'un premier support adapté pour la formation d'une couche de nitrure de gallium GaN et comportant une couche sacrificielle sur laquelle est formée la couche de nitrure de gallium GaN,
- formation, comme illustré sur la figure 9a, d'une couche de nitrure de gallium GaN du deuxième type de conductivité en contact avec la couche sacrificielle, de l'indium In étant ajouté dans le nitrure de gallium GaN pendant la formation de la couche de manière à former les première, deuxième et troisième zones de confinement 211, 212, 213,
- gravure, comme illustré sur la figure 9b, d'une partie de la couche de nitrure de gallium GaN de manière à libérer une partie latérale de ladite couche correspondant à la première région 10,
- formation, comme illustré sur la figure 9c, d'une zone de nitrure de gallium GaN du premier type de conductivité sur la partie libérée lors de l'étape de gravure de manière à former la première région 10,
- formation d'une couche isolante 311 en contact avec la deuxième région 20, ladite couche isolante 311 étant destinée à la formation de la première grille de polarisation 310,
- formation, comme illustré sur la figure 9d, d'une couche conductrice 312 en contact avec la couche isolante 311 qui est destinée à la formation de la première grille de polarisation 310 ceci de manière à former la première grille de polarisation 310,
- séparation de la couche formée par la première et la deuxième région 10, 20 du premier support par gravure sélective de la couche sacrificielle,
- report de la couche formée par la première et la deuxième région 10, 20 sur un substrat conducteur, ladite couche étant mise en contact avec le deuxième substrat au moyen de la première grille de polarisation 310,
- formation d'une couche isolante 321 en contact avec la deuxième région 20, ladite couche isolante 321 étant destinée à la formation de la deuxième grille de polarisation 320,
- formation d'une couche conductrice 322 en contact avec la couche isolante 321 qui est destinée à la formation de la deuxième grille de polarisation 320, ceci de manière à former la deuxième grille de polarisation 320,
- formation du premier et du deuxième contact électrique 410, 420 en contact respectivement de la première région 10 et de la deuxième portion 210 de la deuxième région 20, comme cela est illustré sur la figure 9e.

On peut noter que si dans les modes de réalisation décrits ci-dessus, les zones de confinement 211, 212, 213 sont formées par des puits quantiques, la structure peut comporter un autre type de zones de confinement que des puits quantiques tel que par exemple, des zones dans lesquelles sont disposées des boîtes quantiques ou encore des fils quantiques, ceci sans que l'on sorte du cadre de l'invention.

Si dans les modes de réalisation décrits ci-dessus, la structure 1 décrite comporte trois zones de confinement 211, 212, 213, il est également envisageable, sans que l'on sorte du cadre de l'invention, que la structure 1 comporte uniquement deux zones de confinement ou un nombre de zones de confinement supérieur à trois.

De plus, si dans les différents modes de réalisation décrits, la première grille de polarisation 310 est adaptée pour qu'une polarisation de cette dernière entraîne une modification de la répartition des porteurs majoritaires du deuxième type de conductrivité dans la première portion 210, une telle caractéristique n'exclut pas que la première grille de polarisation 310 peut également être adaptée pour qu'une deuxième polarisation de cette dernière entraîne une modification de la répartition des porteurs majoritaires du premier type de conductivité dans la première portion 210. On peut noter que généralement la deuxième polarisation adéquate, quand l'agencement de la première grille de polarisation autorise une telle possibilité, est inverse de la première polarisation adéquate. Cette dernière remarque s'applique également à la deuxième grille, lorsque la structure en comporte une. Bien entendu ces deux possibillités restent dans le cadre de l'invention puisqu'elles autorisent une modification de la répartition des porteurs d'au moins un type de conductivité parmi le premier et le deuxième type de conductivité et une modification de la répartition des lignes de courant.

Si, dans l'ensemble des modes et variantes de réalisation décrites ci-dessus, le premier et le deuxième moyen de polarisation sont fournis par des grilles de polarisation, il est également envisageable, sans que l'on sorte de l'invention que la structure selon l'invention comporte un autre moyen adapté pour soumettre la première portion à un champ électrique extérieur, tel qu'un contact Schottky, tant que ce dernier est adapté pour permettre une soumission de la première portion à une polarisation extérieure sans injection de porteurs par ce même moyen de polarisation.

De même, si chacun des premier et deuxième moyens de polarisation est, dans les modes et variantes de réalisation décrits ci-dessus, à proximité de l'une parmi la première région et la deuxième portion, il est également envisageable, ceci sans que l'on sorte du cadre de l'invention qu'au moins l'un parmi le premier et le deuxième moyen de polarisation soit agencé à distance de ces mêmes première région et deuxième portion. En effet, si une proximité permet d'obtenir une modification de la répartition des porteurs d'un type de conductivité donné, cette proximité n'est pas nécessaire pour obtenir un effet de champ permettant de modifier la répartition des porteurs d'au moins un type de conductivité.

## Revendications

1. Structure (1) semiconductrice, destinée à émettre de la lumière, comportant :
- une première région (10) semiconductrice d'un premier type de conductivité,
- une deuxième région (20) semiconductrice présentant, au moins sur une portion (220, 210), un deuxième type de conductivité de manière à former une jonction semiconductrice avec la première région (10), cette deuxième région (20) présentant au moins une première portion (210) en contact avec la première région (10) et dans laquelle première portion (210) s'étend au moins partiellement la jonction semiconductrice, cette première portion (210) comprenant au moins une première et une deuxième zone de confinement (211, 212) de porteurs pour au moins un type de porteurs,
la structure **étant caractérisée en ce qu**'elle comporte au moins un premier moyen de polarisation, à opposer à un contact électrique de type ohmique, de la première portion (210) adapté pour soumettre directement la première portion (210) à une première polarisation extérieure afin de modifier la répartition des porteurs d'au moins un type de conductivité dans la première portion (210) par rapport à la première et à la deuxième zone de confinement (211, 212) et sélectionner la ou les zones de confinement dans laquelle l'émission de lumière a lieu,
la première et la deuxième zone de confinement présentant des largeurs de bandes interdites différentes l'une de l'autre.

2. Structure (1) selon la revendication 1, dans laquelle la portion (220) du deuxième type de conductivité, dite deuxième portion, est distincte de la première portion (210).

3. Structure selon la revendication 1, dans laquelle la première portion (210) est la portion du deuxième type de conductivité de la deuxième région.

4. Structure selon l'une quelconque des revendications précédentes, dans laquelle le premier moyen de polarisation est agencé à proximité de l'une parmi la deuxième portion (220) et la première région (10) relativement à l'autre parmi la deuxième portion (220) et la première région (10) de manière qu'une polarisation de ce dernier entraîne dans la première portion (210) une modification de la répartition des porteurs respectivement parmi les porteurs du deuxième type de conductivité et du premier type de conductivité.

5. Structure (1) selon l'une quelconque des revendications 1 à 3, dans laquelle le premier moyen de polarisation est agencé sensiblement à équidistance par rapport à la deuxième portion (220) et de la première région pour qu'une polarisation de ce dernier entraîne une modification de la répartition des porteurs du premier et du deuxième type de conductivité dans la première portion (210).

6. Structure (1) selon l'une quelconque des revendications précédentes, dans laquelle il est en outre prévu un deuxième moyen de polarisation adapté pour soumettre directement la première portion (210) à une deuxième polarisation extérieure afin de modifier la répartition des porteurs d'au moins un type de conductivité dans la première portion par rapport à la première et à la deuxième zone de confinement.

7. Structure (1) selon les revendications 4 et 6, dans laquelle ledit deuxième moyen de polarisation est agencé à proximité de l'autre parmi la deuxième portion (220) et la première région (10) par rapport au premier moyen de polarisation pour qu'une polarisation de ce deuxième moyen de polarisation entraîne une modification dans la première portion (210) de la répartition des porteurs parmi respectivement les porteurs du premier et du deuxième type de conductivité.

8. Structure (1) selon la revendication 2 ou selon la revendication 2 en combinaison avec l'une quelconque des revendications 4 à 7, dans laquelle la première portion (210) est une couche s'étendant selon un plan de couche et comportant une première et une deuxième face, la première et la deuxième zone de confinement (211, 212) s'étendant selon le plan de couche sensiblement parallèlement l'une à l'autre, et dans laquelle la deuxième portion (220) de la deuxième région (20) et le premier moyen de polarisation sont agencés de manière complémentaire sur la deuxième face de la première portion (210).

9. Structure (1) selon l'une quelconque des revendications 1 à 7, dans laquelle la première et la deuxième région (10, 20) se présentent dans une seule couche dite couche active, et dans laquelle la première portion (210) de la deuxième région (20) s'étend longitudinalement selon un plan de couche de la couche active à partir de la première région (10), la première portion (210) présentant une première et une deuxième face longitudinale, la première et la deuxième zone de confinement (211,212) s'étendant selon le plan de couche en regard respectivement de la première et de la deuxième face de la première portion (210), le premier moyen de polarisation étant agencé sur la deuxième face de la première portion (210) .

10. Structure (1) selon la revendication 9 en combinaison avec la revendication 2 seule ou combinée avec l'une quelconque des revendications 4 à 7, dans laquelle la deuxième portion (220) de la deuxième région (20) est en contact avec la première portion (210) sensiblement à l'opposé de la première région (10), la première et la deuxième région (10, 20) étant agencée sous la forme de la couche active.

11. Structure (1) selon les revendications 7 et 9 en combinaison ou non avec la revendication 10, dans laquelle le deuxième moyen de polarisation est agencé sur l'une de la première et de la deuxième face de la première portion (210) de la deuxième région (20) de manière à ce qu'une polarisation du deuxième moyen de polarisation entraîne une modification de la répartition des porteurs du premier type de conductivité dans la première portion (210).

12. Structure (1) selon l'une quelconque des revendications précédentes, dans laquelle le premier moyen de polarisation comporte une couche conductrice (312) séparée de la première portion (210) par une couche de matériau isolant (311), ladite couche conductrice (312) étant positionnée à proximité de la portion (220, 210) de la deuxième région (20) du deuxième type de conductivité.

13. Structure (1) selon l'une quelconque des revendications précédentes, dans laquelle la deuxième région (20) comporte en outre une troisième zone de confinement (213), la première, la deuxième et la troisième zone de confinement (211, 212, 213) présentant des largeurs de bande interdite adaptées pour que les longueurs d'onde d'émission de ces zones de confinement (211, 212, 213) soient réparties sur une partie de la gamme de longueurs d'ondes du visible et préférentiellement sur une majeur partie de la gamme de longueurs d'onde du visible, voire la totalité de la gamme de longueurs d'onde du visible.

14. Procédé de fabrication d'une structure (1) semiconductrice comportant les étapes de :
- fourniture d'une deuxième région (20) semiconductrice comportant au moins une première portion (210) dans laquelle il est prévu une première et une deuxième zone de confinement (211, 212) de porteurs pour au moins un type de porteurs, ladite deuxième région (20) présentant, au moins sur une portion (220, 210), un deuxième type de conductivité, la première et la deuxième zone de confinement présentant des largeurs de bandes interdites différentes l'une de l'autre,
- formation d'une première région (10) semiconductrice d'un premier type de conductivité en contact avec la deuxième région (20) de manière à former une jonction semiconductrice avec la portion (220, 210) de la deuxième région (20) qui est du deuxième type de conductivité, ladite jonction s'étendant dans la première portion (210) de la deuxième région (20),
- formation d'au moins un premier moyen de polarisation, à opposer à un contact électrique de type ohmique, de la première portion (210) de la deuxième région (20) adapté pour modifier la répartition des porteurs d'au moins un type de conductivité dans la première portion (210) par rapport à la première et à la deuxième zone de confinement (211, 212).

15. Dispositif semiconducteur comportant une pluralité de structures (1) semiconductrices destinées à émettre de la lumière, le dispositif étant **caractérisé en ce qu'**il comporte au moins une structure (1) semiconductrice selon l'une quelconque des revendications 1 à 13.

## Patentansprüche

1. Halbleiterstruktur (1), die dazu bestimmt ist, Licht zu emittieren, enthaltend:
- einen ersten Halbleiterbereich (10) mit einem ersten Typ von Leitfähigkeit,
- einen zweiten Halbleiterbereich (20), der zumindest an einem Abschnitt (220, 210) einen zweiten Typ von Leitfähigkeit aufweist, so dass ein Halbleiterübergang mit dem ersten Bereich (10) entsteht, wobei dieser zweite Bereich (20) zumindest einen ersten Abschnitt (210) in Kontakt mit dem ersten Bereich (10) aufweist und wobei der erste Abschnitt (210) sich zumindest teilweise in dem Halbleiterübergang erstreckt, wobei dieser erste Abschnitt (210) zumindest einen ersten und einen zweiten Eingrenzungsbereich (211, 212) von Trägern für zumindest einen Typ von Trägern enthält,
wobei die Struktur **dadurch gekennzeichnet ist, dass** sie zumindest eine einem elektrischen Kontakt vom ohmschen Typ entgegenzusetzende erste Polarisierungseinrichtung zur Polarisierung des ersten Abschnitts (210) enthält, die dazu ausgelegt ist, den ersten Abschnitt (210) direkt einer ersten äußeren Polarisierung zu unterwerfen, um die Verteilung der Träger zumindest eines Typs von Leitfähigkeit in dem ersten Abschnitt (210) bezüglich des ersten und des zweiten Eingrenzungsbereichs (211, 212) zu ändern und den bzw. die Eingrenzungsbereiche auszuwählen, worin die Lichtemission erfolgt,
wobei der erste und der zweite Eingrenzungsbereich Bandlücken aufweisen, die sich voneinander unterscheiden.

2. Struktur (1) nach Anspruch 1, wobei der Abschnitt (220) des zweiten Typs von Leitfähigkeit, zweiter Abschnitt genannt, separat von dem ersten Abschnitt (210) vorliegt.

3. Struktur nach Anspruch 1, wobei es sich bei dem ersten Abschnitt (210) um den Abschnitt des zweiten Typs von Leitfähigkeit des zweiten Bereichs handelt.

4. Struktur nach einem der vorangehenden Ansprüche, wobei die erste Polarisierungseinrichtung in der Nähe von einem aus zweitem Abschnitt (220) und erstem Bereich (10) bezüglich des anderen aus zweitem Abschnitt (220) und erstem Bereich (10) angeordnet ist, so dass eine Polarisierung derselben in dem ersten Abschnitt (210) eine Änderung der Verteilung der Träger jeweils aus den Trägern des zweiten Typs von Leitfähigkeit bzw. des ersten Typs von Leitfähigkeit bewirkt.

5. Struktur (1) nach einem der Ansprüche 1 bis 3, wobei die erste Polarisierungseinrichtung im Wesentlichen im gleichem Abstand von dem zweiten Abschnitt (220) und dem ersten Bereich angeordnet ist, damit eine Polarisierung derselben eine Änderung der Verteilung der Träger des ersten und des zweiten Typs von Leitfähigkeit in dem ersten Abschnitt (210) bewirkt.

6. Struktur (1) nach einem der vorangehenden Ansprüche, wobei ferner eine zweite Polarisierungseinrichtung vorgesehen ist, die dazu ausgelegt ist, den ersten Abschnitt (210) direkt einer zweiten äußeren Polarisierung zu unterwerfen, um die Verteilung der Träger zumindest eines Typs von Leitfähigkeit in dem ersten Abschnitt bezüglich des ersten und des zweiten Eingrenzungsbereichs zu verändern.

7. Struktur (1) nach den Ansprüchen 4 und 6, wobei die zweite Polarisierungseinrichtung in der Nähe des anderen aus zweitem Abschnitt (220) und erstem Bereich (10) bezüglich der ersten Polarisierungseinrichtung angeordnet ist, damit eine Polarisierung dieser zweiten Polarisierungseinrichtung in dem ersten Abschnitt (210) eine Änderung der Verteilung der Träger jeweils aus den Trägern des ersten bzw. des zweiten Typs von Leitfähigkeit bewirkt.

8. Struktur (1) nach Anspruch 1 oder Anspruch 2 in Kombination mit einem der Ansprüche 4 bis 7, wobei der erste Abschnitt (210) eine Schicht ist, die sich in einer Schichtebene erstreckt, und eine erste und eine zweite Seite enthält, wobei der erste und der zweite Eingrenzungsbereich (211, 212) sich in der Schichtebene im Wesentlichen parallel zueinander erstrecken, und wobei der zweite Abschnitt (220) des zweiten Bereichs (20) und die erste Polarisierungseinrichtung an der zweiten Seite des ersten Abschnitts (210) komplementär angeordnet sind.

9. Struktur (1) nach einem der Ansprüche 1 bis 7, wobei der erste und der zweite Bereich (10, 20) in einer einzigen Schicht, Wirkschicht genannt, vorliegen und wobei der erste Abschnitt (210) des zweiten Bereichs (20) sich longitudinal in einer Schichtebene der Wirkschicht ausgehend von dem ersten Bereich (10) erstreckt, wobei der erste Abschnitt (210) eine erste und eine zweite Längsseite aufweist, wobei der erste und der zweite Eingrenzungsbereich (211, 212) sich in der Schichtebene jeweils der ersten bzw. der zweiten Seite des ersten Abschnitts (210) gegenüberliegend erstrecken, wobei die erste Polarisierungseinrichtung an der zweite Seite des ersten Abschnitts (210) angeordnet ist.

10. Struktur (1) nach Anspruch 9 in Kombination mit Anspruch 2 allein oder in Kombination mit einem der Ansprüche 4 bis 7, wobei der zweite Abschnitt (220) des zweiten Bereichs (20) mit dem ersten Abschnitt (210) im Wesentlichen dem ersten Bereich (10) entgegengesetzt in Kontakt steht, wobei der erste und der zweite Bereich (10, 20) in Form von der Wirkschicht angeordnet sind.

11. Struktur (1) nach den Ansprüchen 7 und 9 in Kombination oder nicht in Kombination mit Anspruch 10, wobei die zweite Polarisierungseinrichtung an einer aus erster und zweiter Seite des ersten Abschnitts (210) des zweiten Bereichs (20) so angeordnet ist, dass eine Polarisierung der zweiten Polarisierungseinrichtung eine Änderung der Verteilung der Träger des ersten Typs von Leitfähigkeit in dem ersten Abschnitt (210) bewirkt.

12. Struktur (1) nach einem der vorangehenden Ansprüche, wobei die erste Polarisierungseinrichtung eine leitfähige Schicht (312) enthält, die durch eine Isoliermaterialschicht (311) von dem ersten Abschnitt (210) getrennt ist, wobei die leitfähige Schicht (312) in der Nähe des Abschnitts (220, 210) des zweiten Bereichs (20) des zweiten Typs von Leitfähigkeit positioniert ist.

13. Struktur (1) nach einem der vorangehenden Ansprüche, wobei der zweite Bereich (20) ferner einen dritten Eingrenzungsbereich (213) enthält, wobei der erste, der zweite und der dritte Eingrenzungsbereich (211, 212, 213) Bandlücken aufweisen, die dazu ausgelegt sind, dass die Emissionswellenlänge dieser Eingrenzungsbereiche (211, 212, 213) über einen Teil des Längswellenbereichs des sichtbaren Lichts und vorzugsweise über einen Großteil des Wellenlängenbereichs des sichtbaren Lichts bzw. über den gesamten Wellenlängenbereich des sichtbaren Lichts verteilt sind.

14. Verfahren zum Herstellen einer Halbleiterstruktur (1), umfassend die nachfolgenden Schritte:
- Bereitstellen eines zweiten Halbleiterbereichs (20), der zumindest einen ersten Abschnitt (210) aufweist, in welchem ein erster und ein zweiter Eingrenzungsbereich (211, 212) von Trägern für zumindest einen Typ von Trägern vorgesehen ist, wobei der zweite Bereich (20) zumindest an einem Abschnitt (220, 210) einen zweiten Typ von Leitfähigkeit aufweist, wobei der erste und der zweite Eingrenzungsbereich Bandlücken aufweisen, die sich voneinander unterscheiden,
- Ausbilden eines ersten Halbleiterbereichs (10) eines ersten Typs von Leitfähigkeit in Kontakt mit dem zweiten Bereich (20), so dass ein Halbleiterübergang mit dem Abschnitt (220, 210) des zweiten Bereichs (20) entsteht, der vom zweiten Typ von Leitfähigkeit ist, wobei der Übergang sich in dem ersten Abschnitt (210) des zweiten Bereichs (20) erstreckt,
- Ausbilden zumindest einer eine einem elektrischen Kontakt vom ohmschen Typ entgegenzusetzende ersten Polarisierungseinrichtung zum Polarisieren des ersten Abschnitts (210) des zweiten Bereichs (20), die dazu ausgelegt ist, die Verteilung der Träger zumindest eines Typs von Leitfähigkeit in dem ersten Abschnitt (210) bezüglich des ersten und des zweiten Eingrenzungsbereichs (211, 212) zu ändern.

15. Halbleitervorrichtung mit einer Mehrzahl von Halbleiterstrukturen (1), die dazu bestimmt sind, Licht zu emittieren, wobei die Vorrichtung **dadurch gekennzeichnet ist, dass** sie zumindest eine Halbleiterstruktur (1) nach einem der Ansprüche 1 bis 13 enthält.

## Claims

1. A semiconducting structure (1) intended to emit light, comprising:
- a first semiconducting region (10) with a first type of conductivity,
- a second semiconducting region (20) with a second type of conductivity at least on a portion (220, 210), so as to form a semiconducting junction with the first region (10), the second region (20) having at least one first portion (210) in contact with the first region (10), in which the first portion extends at least partially along the semiconducting junction, this first portion (210) comprising at least a first and a second carrier confinement zone (211, 212) for at least one type of carrier,
the semiconducting structure being **characterized in that** it comprises at least a first means of polarisation, different from a resistive type of electrical contact, of the first portion (210) adapted to apply direct first external polarisation to the first portion (210) in order to modify the distribution of carriers of at least one type of conductivity in the first portion (210) relative to the first and the second confinement zones (211, 212) and to select the confinement zone(s) in which light emission takes place,
the first and second confinement zones having different band gap widths.

2. The structure (1) according to claim 1, wherein the portion (220) with the second type of conductivity, called the second portion, is distinct from the first portion (210).

3. The structure according to claim 1, wherein the first portion (210) is the portion with the second type of conductivity in the second region.

4. The structure according to any one from the preceding claims, wherein the first polarisation means is located close to one among the second portion (220) and the first region (10) relative to the other among the second portion (220) and the first region (10) such that polarisation of the latter modifies the distribution in the first portion (210) of carriers among carriers with the second type of conductivity and the first type of conductivity, respectively.

5. The structure (1) according to any one from the preceding claims, wherein the first polarisation means is located at approximately equal distances from the second portion (220) and the first region such that polarisation of the latter modifies the distribution of carriers with the first and second types of conductivity in the first portion (210).

6. The structure (1) according to any one from the preceding claims, wherein a second polarisation means adapted to apply direct second external polarisation to the first portion (210) is also provided, to modify the distribution of carriers of at least one type of conductivity in the first portion relative to the first and the second confinement zones.

7. The structure (1) according to claims 4 and 6, wherein the second polarisation means is located close to the other among the second portion (220) and the first region (10) relative to the first polarisation means such that polarisation of this second polarisation means modifies the distribution in the first portion (210) of carriers among the carriers of the first and second types of conductivity respectively.

8. The structure (1) according to claim 2 or according to claim 2 combined to any one from claims 4 to 7, wherein the first portion (210) is a layer extending along a layer plane and comprising a first and a second face, the first and second confinement zones (211, 212) extending along the layer plane approximately parallel to each other, and wherein the second portion (220) of the second region (20) and the first polarisation means are located in a complementary manner on the second face of the first portion (210).

9. The structure (1) according to any one from claims 1 to 7, wherein the first and the second regions (10, 20) are ensclosed in a single layer, said active layer, the first portion (210) of the second region (20) extends along a layer plane of the active layer from the first region (10), the first portion (210) having a first and a second longitudinal face, the first and the second confinement zones (211,212) extending along the layer plane facing the first and the second face of the first portion (210) respectively, the first polarisation means being located on the second face of the first portion (210).

10. The structure (1) according to claim 9 combined with claim 2 alone or combined with any one form claims 4 to 7, wherein the second portion (220) of the second region (20) is in contact with the first portion (210) approximately opposite the first region (10), the first and the second regions (10, 20) being arranged to form a layer.

11. The structure (1) according to claim 7 and 9 taken or not in combinaison with claim 10, wherein the second polarisation means is located on one of the first and second faces of the first portion (210) of the second region (20) such that polarisation of the second polarisation means modifies the distribution of carriers with the first type of conductivity in the first portion (210).

12. The structure (1) according to to any one from the preceding claims, wherein the first polarisation means comprises a conducting layer (312) separated from the first portion (210) by a layer of insulating material (311), tue conducting layer (312) being located close to the portion (220, 210) of the second region (20) with the second type of conductivity.

13. The structure (1) according to any one from the preceding claims, wherein the second region (20) also comprises a third confinement zone (213), the first, the second and the third confinement zones (211, 212, 213) having band gap widths such that emission wavelengths of these confinement zones (211, 212, 213) are distributed over part of the range of visible wavelengths and preferably over most of the range of visible wavelengths, or even over the entire range of visible wavelengths.

14. A method of manufacturing a semiconducting structure (1) comprising the following steps:
- supply a second semiconducting region (20) comprising at least one first portion (210) in which there are first and second carrier confinement zones (211, 212) for at least one type of carrier, said second region (20) having a second type of conductivity, at least on one portion (220, 210),
- formation of a first semiconducting region (10) with a first type of conductivity in contact with the second region (20) so as to form a semiconducting junction with the portion (220, 210) of the second region (20) with the second type of conductivity, the junction extending in the first portion (210) of the second region (20),
- formation of at least one first means of polarising the first portion (210) of the second region (20) adapted to modify the distribution of carriers with at least one type of conductivity in the first portion (210) relative to the first and to the second confinement zones (211, 212).

15. A semiconducting device comprising a plurality of semiconducting structures (1) that will emit light, the device being **characterised in that** it comprises at least one semiconducting structure (1) according to any one from claims 1 to 13.
